Europäisches Patentamt

European Patent Office

Office européen des brevets

(19)

(11) Numéro de publication: **0 010 462**
**B1**

(12) **FASCICULE DE BREVET EUROPEEN**

(45) Date de publication du fascicule du brevet: **20.06.84**

(51) Int. Cl.³: **H 03 D 3/04, H 04 B 1/18**

(21) Numéro de dépôt: **79400653.6**

(22) Date de dépôt: **18.09.79**

(54) **Dispositif de démodulation de fréquence et récepteur comportant un tel dispositif.**

(30) Priorité: **29.09.78 FR 7827917**

(43) Date de publication de la demande:
**30.04.80 Bulletin 80/9**

(45) Mention de la délivrance du brevet:
**20.06.84 Bulletin 84/25**

(84) Etats contractants désignés:
**DE GB**

(56) Documents cités:
**CH - A - 549 217**
**FR - A - 1 468 911**
**US - A - 3 307 112**
**US - A - 3 320 434**
**US - A - 3 473 133**
**US - A - 3 614 634**
**US - A - 3 723 891**

(73) Titulaire: **THOMSON-CSF**
**173, Boulevard Haussmann**
**F-75379 Paris Cedex 08 (FR)**

(72) Inventeur: **Claverie, Claude**
**Thomson-CSF - SCPI 173, bld Haussmann**
**F-75360 Paris Cedex 08 (FR)**

(74) Mandataire: **Courtellemont, Alain et al,**
**THOMSON-CSF SCPI 173, Bld Haussmann**
**F-75379 Paris Cedex 08 (FR)**

Courier Press, Leamington Spa, England.

## Description

La présente invention concerne les dispositifs permettant de démoduler des ondes modulées en fréquence et en particulier les dispositifs simples fonctionnant jusqu'à des fréquences porteuses de quelques dizaines de mégahertz.

Pour démoduler une onde modulée en fréquence, il est connu de générer à partir de cette onde des impulsions de durée déterminée et indépendante de la fréquence de l'onde modulée, puis d'intégrer ces impulsions afin d'obtenir une valeur moyenne de ces impulsions qui soit proportionnelle à la fréquence de récurrence de celles-ci donc à la fréquence de l'onde modulée.

Plusieur dispositifs permettent de réaliser cette fonction, parmi ceux-ci le plus performant utilise un circuit limiteur disposé en série avec une bascule monostable et un filtre passe-bas.

Le circuit limiteur écrête le signal modulé en fréquence fournissant ainsi des signaux carrés modulés en fréquence à partir desquels la bascule monostable délivre des impulsions, de durée déterminée et constante, dont le filtre passe-bas extrait la valeur moyenne.

Les inconvénients de ce dispositif sont dûs à la nécessité d'avoir des temps de montée et de descente de ces impulsions qui soient très brefs si l'on désire obtenir un fonctionnement correct (valeur moyenne du signal obtenu en sortie du dispositif proportionnelle à la fréquence) à des fréquences de quelques dizaines de mégahertz.

D'auties dispositifs de demodulation pour signaux modulés en frequence ont été décrits dans les brevets US—A—3 320 434 et US—A—3 307 112. Dans le brevet US—A—3 320 434, le dispositif décrit permet d'obteniz un signal proportionnel à la fréquence du signal d'entrée par une integration, après écrétage, par l'intermédiaire d'un dispositif à seuil engendrant une série d'impulsions de durée proportionnelle à la frequence du signal d'entrée. Dans le brevet US—A—3 307 112, une intégration des signaux après écrétage ne permet cependant pas d'obtenir un signal de sortie de valeur moyen ne proportionnelle à la fréquence du signal d'entre modulé on Frequence selon un code binaire.

La présente invention a pour but de remédier à cet inconvénient.

Selon l'invention, un dispositif de démodulation permettant de démoduler des signaux modulés en fréquence, comportant des moyens de limitation d'amplitude recevant le signal à démoduler, pour transformer le signal à démoduler en suites de signaux carrés ou rectangulaires modulés en fréquence, couplé à un filtre passe-bas par l'intermédiaire de moyens d'intégration disposés entre des moyens de limitation et le filtre passe-bas, est caractérisé en ce que les moyens d'intégration intègrent les signaux de sortie du limiteur selon une première constante d'intégration et jusqu'à une valeur prédéterminée de tension lorsque le signal appliqué à leur entrée a une premier état et sont remis à zéro selon une deuxième constante d'intégration très inférieure à la première constant d'intégration lorsque le signal appliqué à leur entrée a un deuxième état, la tension de valeur prédéterminée étant telle que le temps d'intégration soit inférieur à la moitié de la période minimale du signal à démoduler, le filtre passe bas permettant d'extraire la valeur moyenne du signal fourni par le moyens d'intégration.

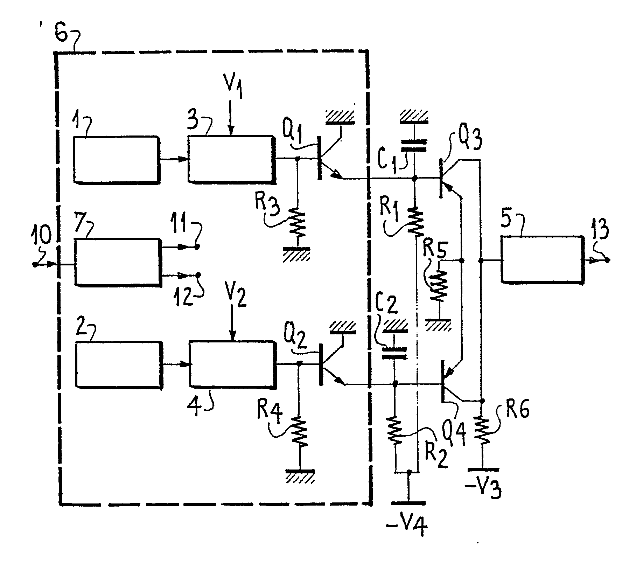

L'invention sera mieux comprise et d'autres caractéristiques apparaîtront à l'aide de la description ci-après et du dessin s'y rapportant qui représente un mode de réalisation préferé du dispositif selon l'invention.

Sur cette figure un circuit limiteur 6 reçoit sur une borne d'entrée 10, qui est également l'entrée du dispositif de démodulation, des signaux à démoduler. Ce circuit comporte une résistance $R_3$ ayant une première borne reliée à une source de courant I à travers un interrupteur électronique 3 commandé par un signal $V_1$, et une seconde borne reliée à la masse. La première borne de cette résistance $R_3$ est également reliée à la base d'un transistor bipolaire NPN, $Q_1$, dont le collecteur est relié à la masse et dont l'émetteur constitue une sortie directe d'un circuit limiteur d'amplitude 6. Une résistance $R_4$ a une première borne reliée à une source de courant 2 à travers un interrupteur électronique 4 commandé par un signal $V_2$, et une seconde borne reliée à la masse.

La première borne de cette résistance $R_4$ est également reliée à la base d'un transistor bipolaire NPN, $Q_2$, dont le collecteur est relié à la masse et dont l'emetteur constitue une sortie inversée du circuit limiteur d'amplitude 6. Les signaux $V_1$ et $V_2$ sont complémentaires ($V_2 = \overline{V_1}$) et sont respectivement fournis par les bornes de sortie 11 et 12 d'un circuit de mise en forme 7 recevant sur son entrée 10 le signal modulé en fréquence.

Il est à noter que dans la présente réalisation ce circuit limiteur d'amplitude 6 est un comparateur AM 685 d'Advanced Micro Devices dont l'entrée (+) reçoit le signal à limiter et dont l'entrée (−) est reliée à la masse.

L'émetteur du transistor $Q_1$ est relié à la masse à travers un condensateur $C_1$ d'intégration, à une tension d'alimentation $V_4$ négative à travers une résistance $R_1$, et à la base d'un transistor bipolaire PNP dont l'émetteur est relié à la masse, à travers une résistance $R_5$, et dont le collecteur est relié d'une part à la borne de sortie 13, à travers un filtre passe-bas 5, et d'autre part à une tension d'alimentation $V_3$ négative à travers une résistance $R_6$.

L'émetteur du transistor $Q_2$ est relié à la masse à travers un condensateur $C_2$ d'intégration, à la tension $V_4$ à travers une résistance $R_2$, et à la base d'un transistor $Q_4$, dont l'émetteur est relié à la masse, à travers une résistance $R_5$, et dont le collecteur est relié d'une part à la borne de sortie 13, à travers le filtre passe-bas 5, et d'autre part à la tension d'alimentation $V_3$ à travers la résistance $R_6$.

Il est à noter que les transistors $Q_3$ et $Q_4$ sont choisis de type opposé à celui des transistors $Q_1$ et $Q_2$ afin de réduire les dérives en température du dispositif (compensation des dérives en température des tensions base-émetteur).

Le fonctionnement de ce dispositif est le suivant:

Les sources de courant 1 et 2 fournissent chacune un courant continu de valeur $I_o$.

Lorsque la valeur de la tension d'entrée appliquée à la borne 10 est positive le circuit de mise en forme 7 délivre une tension $V_1$, sur sa borne de sortie 11, et permet de fermer l'interrupteur 3, et une tension $V_2$ de valeur nulle qui laisse l'interrupteur 4 ouvert. Inversement lorsque la valeur de la tension d'entrée appliquée à la borne 10 est négative l'interrupteur 4 est fermé et l'interrupteur 3 est ouvert.

Lorsque l'interrupteur 3 est ouvert le potentiel de base du transistor $Q_1$ est égal au potentiel de son collecteur, ce qui a pour effet de saturer ce transistor et de remettre à zéro la tension aux bornes du condensateur d'intégration $C_1$; les charges éventuellement stockées dans le condensateur $C_1$ sont écoulées à la masse acec une faible constante de temps $\tau_1$ donnée par la relation suivante:

$\tau_1 = R'C_1$ si $R'$ est la résistance de la double jonction collecteur-émetteur du transistor saturé $Q_1$

Lorsque l'interrupteur 3 est fermé le potentiel de base du transistor $Q_1$ est égal à $-R_3 . I_o$ compte-tenu du sens du courant $I_o$ (courant $I_o$ circulant de la résistance $R_3$ vers la source de courant 1). En conséquence le transistor $Q_1$ est bloqué et le condensateur $C_1$ est chargé avec une constante de temps $\tau_2$ donnée par la relation suivante:

$\tau_2 = R_1 . C_1$

Ce condensateur $C_1$ se chargerait jusqu'à ce que la valeur de la tension à ses bornes soit égale à $-V_4$ mais pour une valeur de cette tension égale à $-R_3 . I_o - V_{BE}$ le transistor $Q_1$ commence à conduire ($V_{BE}$ étant la tension entre la base et l'émetteur de ce transistor) et la tension aux bornes du condensateur $C_1$ reste bloquée à cette dernière valeur.

Il est à noter que pour cette réalisation la valeur de la tension $-V_4$ est très grande en valeur absolue par rapport à la tension $-R_3 . I_o - V_{BE}$, ce qui permet une charge quasi-linéaire du condensateur $C_1$.

Lorsque l'interrupteur 3 est ouvert le cycle recommence comme précédemment.

Le transistor $Q_3$ connecté en émetteur commun transmet ces variations de tension à la sortie 13 à travers le filtre passe-bas 5 en inversant la phase de ces variations de tension et en les amplifiant.

L'ensemble comportant la source de courant 2, l'interrupteur 4, les résistances $R_4$ et $R_2$, le condensateur $C_2$ et les transistors $Q_2$ et $Q_4$ fonctionne comme leurs éléments correspondants, ayant la même valeur ($R_3 = R_4$, $C_2 = C_1$, $R_2 = R_1$) précédemment décrits mais les signaux obtenus sont en opposition de phase du fait que les signaux de commande $V_1$ et $V_2$ sont complémentaires.

Les signaux de ces deux ensembles sont sommés dans la charge commune de collecteur des transistors $Q_3$ et $Q_4$ puis filtrés par le filtre passe-bas 5 qui permet d'en extraire leur valeur moyenne.

Il est à noter que la sommation, non indispensable, des deux voies permet de multiplier par deux la valeur de l'amplitude du signal démodulé, mais aussi de multiplier par deux la valeur des différentes fréquences qui doivent être éliminées par le filtre passe-bas 5, ce qui finalement facilite le problème de filtrage.

L'expérience montre et le calcul confirme que cette valeur moyenne est proportionnelle à la fréquence de l'onde reçue sur la borne d'entrée 10; ce dispositif constitue donc un démodulateur de fréquence.

Il est à noter que pour que ce dispositif fonctionne correctement il faut que le temps de charge des condensateurs $C_1$ ou $C_2$ (temps nécessaire pour que la tension aux bornes de ceux-ci passe d'une tension voisine de Ov à $-R_3 . I_o - V_{BE}$) soit inférieur à la moitié de la période des signaux fournis aux bornes des résistances $R_3$ ou $R_4$.

L'invention n'est pas limitée au mode de réalisation décrit et représenté, en particulier le dispositif est susceptible de variantes parmi lesquelles on notera les suivantes:

Pour limiter la valeur du courant crête de décharge des condensateurs $C_1$ et $C_2$ on insère entre ces condensateurs et la masse une faible résistance.

Pour recueillir un signal démodulé de polarité opposée, le filtre passe-bas 5 peut être connecté sur les émetteurs couplés des transistors $Q_3$ et $Q_4$.

De tels dispositifs sont notamment utilisables dans les récepteurs à modulation de fréquence.

**Revendications**

1. Dispositif de démodulation permettant de démoduler des signaux modulés en fréquence, comportant des moyens de limitation d'amplitude recevant le signal à démoduler en suites de signaux rectangulaires modulés en fréquence couplé à un filtre passe-bas (5) par l'intermédiaire de moyens d'intégration ($R_1 . C_1$; $R_2 . C_2$) disposés entre des moyens de limitation (6) et le filtre passe-bas (5), caractérisé en ce que les moyens d'intégration ($R_1 . C_1$; $R_2 . C_2$) intègrent linéairement les signaux de sortie du limiteur selon une première constante d'intégration ($\tau_2$) et jusqu'à une valeur prédéterminée de tension lorsque le signal appliqué à leur entrée a un premier état et sont remis à zéro selon une deuxième constante d'intégration ($\tau_1$) très inférieure à la première constante d'intégration lorsque le signal appliqué à leur entrée a un deuxième état, la tension de valeur prédéterminée étant telle que le temps d'intégration soit inférieur à la moitié de la période minimale du signal à démoduler, et en ce que le filtre passe-bas (5) a son entrée connectee en sortie des moyens d'intégration ($R_1C_1$—$R_2C_2$) pour extraire la valeur moyenne du signal fourni pas les moyens d'intégration.

2. Dispositif de démodulation selon la revendication 1 où les moyens de limitation d'amplitude (6) comportent une sortie directe et une sortie inversée, caractérisé en ce que les moyens d'intégration comportent deux voies identiques ($Q_3.C_1$; $Q_4.C_2$) couplées respectivement à la sortie directe et à la sortie inversée des moyens de limitation d'amplitude, en ce que chaque voie comporte un transistor ($Q_3$, $Q_4$) dont la base est couplée à la sortie correspondante des moyens de limitation d'amplitude (6) et dont la sortie est couplée à l'entrée du filtre passe-bas (5), un condensateur ($C_1$, $C_2$) et une résistance ($R_1$, $R_2$) pour coupler respectivement la base du transistor à la masse et à une source de tension de référence ($-V_1$), et en ce que chaque condensateur est chargé par la tension de référence à travers la résistance correspondante jusqu'à la tension de valeur prédéterminée ($-R_3.I_o$—$V_{BE}$) suivant la première constante de temps ($\tau_2$) puis déchargé à travers le limiteur d'amplitude suivant la seconde constante de temps ($\tau_1$).

3. Dispositif de démodulation selon la revendication 2, caractérisé en ce que pour chacune des voies une résistance supplémentaire est insérée entre la masse et le condensateur.

4. Dispositif de démodulation selon la revendication 2, caractérisé en ce que chaque transistor ($Q_3$, $Q_4$) est connecté en émetteur commun et en ce que le collecteur de chacun des transistors est couplé à l'entrée du filtre passe-bas (5).

5. Dispositif de démodulation selon la revendication 2, caractérisé en ce que chaque transistor est connecté en collecteur commun et en ce que l'émetteur de chacun des transistors est couplé à l'entrée du filtre passe-bas.

6. Utilisation d'un dispositif de démodulation de fréquence selon l'une quelconque des revendications précédentes dans un récepteur.

**Patentansprüche**

1. Demoduliervorrichtung zum Demodulieren frequenzmodulierter Signale, mit Amplitudenbegrenzungsmitteln, die das zu demodulierende Signal in Form von Reihen frequenzmodulierten rechteckiger Signale empfangen, das über zwischen Begrenzungsmitteln (6) und einem Tiefpassfilter (5) angeordnete Integriermittel ($R_1.C_1$; $R_2.C_2$) an den Tiefpassfilter (5) angekoppelt ist, dadurch gekennzeichnet, dass die Integriermittel ($R_1.C_1$; $R_2.C_2$) die Ausgangssignale des Begrenzers nach Massnahme einer ersten Integrationskonstante ($\tau_2$) bis zu einem vorbestimmten Spannungswert linear integrieren, wenn das an den Eingang dieser Integriermittel angelegte Signal sich in einem ersten Zustand befindet, während bie Integriermittel nach Massgabe einer zweiten Integrationskonstante ($\tau_1$), die erheblich kleiner ist, als die erste Integrationskonstante, auf Null rückgestellt werden, wenn das an den Eingang dieser Integriermittel angelegte Signal sich in einem zweiten Zustand befindet, wobei die den vorbestimmten Wert besitzende Spannung derart gewählt ist, dass die Integrationszeit kürzer ist, als die Hälfte der Mindestperiode des zu demodulierenden Signals, und ferner dadurch gekennzeichnet, dass der Eingang des Tiefpassfilters (5) an den Ausgang der Integriermittel ($R_1.C_1$; $R_2.C_2$) angeschlossen ist, um den Mittelwert des von den Integriermitteln gelieferten Signales zu ermitteln.

2. Demoduliervorrichtung nach Anspruch 1, bei der die Amplitudenbegrenzungsmittel (6) einen direkten Ausgang und einen umgeschalteten Ausgang umfassen, dadurch gekennzeichnet, dass die Integriermittel zwei identische Kanäle ($Q_3.C_1$; $Q_4.C_2$) umfassen, deren einer an den direkten Ausgang und deren anderer an den umgeschalteten Ausgang der Amplitudenbegrenzungsmittel angeschlossen ist, dass jeder Kanal einen Transistor ($Q_3$, $Q_4$) aufweist, dessen Basiselektrode an den entsprechenden Ausgang der Amplitudenbegrenzungsmittel (6) angekoppelt ist, und dessen Ausgang an den Eingang des Tiefpassfilters (5) angekoppelt ist, ferner einen Kondensator ($C_1$, $C_2$) und einen Widerstand ($R_1$, $R_2$), um die Basiselektrode des Transistors zu erden bzw. an eine Bezugsspannungsquelle ($-V_1$) anzulegen, und dass jeder Kondensator nach Massgabe der ersten Zeitkonstante ($\tau_2$) über den entsprechenden Widerstand mit der Bezugsspannung geladen wird, bis die Spannung vorbestimmten Wertes ($-R_3.I_o$—$V_{BE}$) erreicht ist, und der Kondensator sodann nach Massgabe der zweiten Zeitkonstante ($\tau_1$) über den Amplitudenbegrenzer entladen wird.

3. Demoduliervorrichtung nach Anspruch 2, dadurch gekennzeichnet, dass für jeden der Kanäle zwischen der Erde und dem Kondensator ein zusätzlicher Widerstand eingeschaltet ist.

4. Demoduliervorrichtung nach Anspruch 2, dadurch gekennzeichnet, dass jeder Transistor ($Q_3$, $Q_4$) als gemeinsamer Emitter geschaltet ist, und dass der Kollektor eines jeden Transistors an den Eingang des Tiefpassfilters (5) angekoppelt ist.

5. Demoduliervorrichtung nach Anspruch 2, dadurch gekennzeichnet, dass jeder Transistor als gemeinsamer Kollektor geschaltet isdt, und dass der Emitter eines jeden Transistors an den Eingang des Tiefpassfilters angekoppelt ist.

6. Anwendung einer Frequenzdemoduliervorrichtung nach einem der vorstehenden Ansprüche in einem Empfangsgerät.

**Claims**

1. Demodulating device allowing to demodulate frequency modulated signals, comprising amplitude limitation means receiving the signal to be demodulated in sequences of rectangular signals modulated in frequency coupled to a low-pass filter (5) through the intermediary of integration means $(R_1 . C_2; R_2 . C_2)$ disposed between the limitation means (6) and the low-pass filter (5), characterized in that the integration means $(R_1 . C_1; R_2 . C_2)$ integrate linear-wise the output signals of the limiter according to a first integration constant $(\tau_2)$ and up to a predetermined voltage value when the signal applied at their input has a first state and are reset at zero according to a second integration constant $(\tau_1)$ far lower than the first integration constant when the signal applied at their input has a second state, the predetermined voltage value being such that the integration time is less than half the minimal period of the signal to be demodulated, and in that the low-pass filter (5) has its input connected to the output of integration means $(R_1 . C_1 — R_2 . C_2)$ in order to extract the average value of the signal supplied by the integration means.

2. Demodulating device according to claim 1, in which the amplitude limitation means (6) comprise a direct output and a reversed output, characterized in that the integration means comprise two identical paths $(Q_3 . C_1; Q_4 . C_2)$ coupled respectively to the direct output and the reversed output of the amplitude limitation means, in that each path comprises a transistor $(Q_3, Q_4)$, the base of which is coupled to the corresponding output of the amplitude limitation means (6) and the output of which is coupled to the input of the low-pass filter (5), a capacitor $(C_1, C_2)$ and a resistor $(R_1, R_2)$ in order to couple respectively the base of the transistor to the earth and a reference voltage supply $(—V_1)$, and in that each capacitor is charged by the reference voltage through the corresponding resistor until the predetermined voltage value $(—R_3 . I_o —V_{BE})$ according to the first time constant $(\tau_2)$ then discharged through the amplitude limiter according to the second time constant $(\tau_1)$.

3. Demodulating device according to claim 2, characterized in that for each of the paths a supplementary resistor is inserted between the earth and the capacitor.

4. Demodulating device according to claim 2, characterized in that each transistor $(Q_3, Q_4)$ is connected to a common emitter and in that the collector of each of the transistors is coupled to the input of the low-pass filter (5).

5. Demodulating device according to claim 2, characterized in that each transistor is collected to a common collector and in that the emitter of each of the transistors is coupled to the input of the low-pass filter.

6. Utilization of a demodulating frequency device according to any one of the preceding claims in a receiver.